# EUROPEAN PATENT APPLICATION

(11) **EP 4 462 958 A1**
(43) Date of publication of application: **13.11.2024**
(21) Application number: 24170404.8
(22) Date of filing: 16.04.2024
(51) Int. Cl.: H05K 1/02, H05K 3/46

(54) **COMPONENT CARRIER WITH ALIGNED THROUGH HOLES, AND METHOD FOR EVALUATING A COMPONENT CARRIER**

(30) Priority: 08.05.2023 CN 202310507811
(71) Applicant: AT & S Austria Technologie & Systemtechnik Aktiengesellschaft, 8700 Leoben-Hinterberg (AT)
(72) Inventor: WEI, Vivi, Chongqing, 401120 (CN); WANG, Nina, Chongqing, 401133 (CN); CHEN, Ed, Chongqing, 401133 (CN); JIANG, Jeffrey, Chongqing, 401133 (CN); BAFTIRI, Artan, Chongqing, 401121 (CN)
(74) Representative: Donatello, Daniele

(57) **Abstract**

Component carrier (100) comprising a stack, having:
a first electrically conductive layer structure (102) with a first through hole (110);
a second electrically conductive layer (104) structure with a second through hole (112); and
at least one electrically insulating layer structure (106), comprising a first insulating material (114), arranged between the first electrically conductive layer structure (102) and the second electrically conductive layer structure (104);
wherein the first through hole (110) and the second through hole (112) are aligned in the stacking direction (z) of the stack.

## Description

### Field of the Invention

The invention relates to a component carrier comprising a stack, having a first electrically conductive layer structure with a first through hole, a second electrically conductive layer structure with a second through hole, and at least one electrically insulating layer structure, comprising a first insulating material, arranged between the first electrically conductive layer structure and the second electrically conductive layer structure. Further, the invention relates to a method for evaluating a component carrier having such structure.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, a central problem present in the miniaturization of the component carriers may be the possibility of reliably evaluating the quality, in particular the manufacturing quality, of the component carrier, in particular during (in-line of) the manufacturing process.

To obviate such problems, test areas having so-called fiducial structures are conventionally used. Such fiducial structures, also called circuit pattern recognition marks, are structures present on the component carrier and are in particular represented by a through hole comprised in an electrically conducting layer structure, which can be sensed by a sensor (e.g. a camera). The imaging system can then evaluate, on base of the perceived structure-image, if the component carrier has a minimum standard quality.

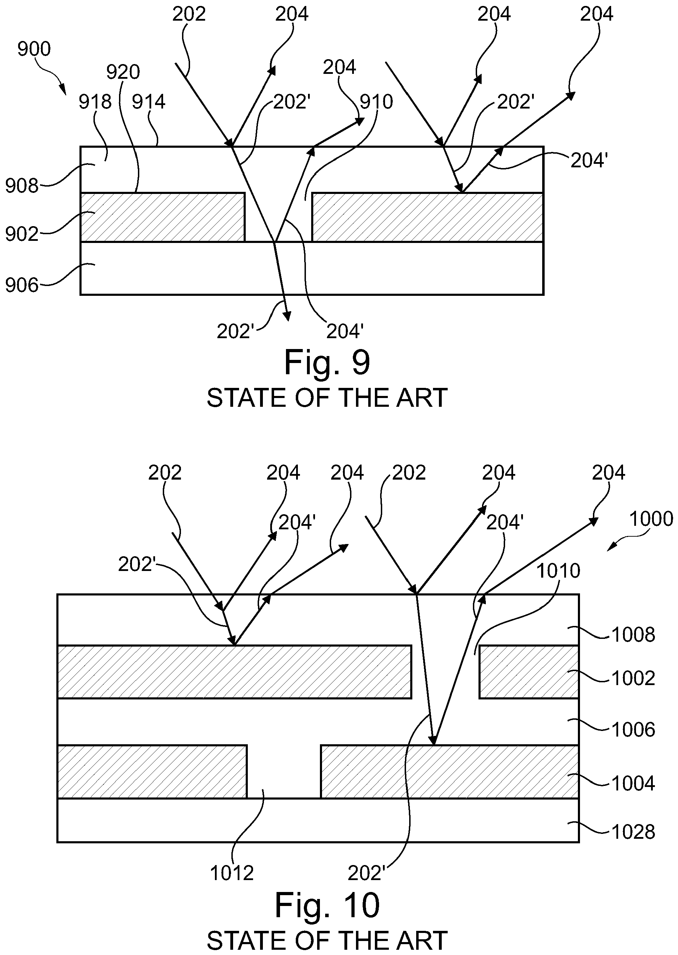

A component carrier according to the prior art is shown in **Figure 9****.** The component carrier 900 has a second electrically insulating layer structure 908, a first electrically conductive layer structure 902 and a core layer structure 906 stacked together. The first electrically conductive layer structure 902 has a through hole 910, also referred to as fiducial in this case, used for evaluating the quality of the component carrier 900, in particular during the manufacturing process. To perform the method, an incident electromagnetic radiation beam 202 is directed towards the component carrier 900. The incident electromagnetic radiation beam 202 is partly reflected at an outer surface 918 of the electrically insulating layer structure 908 as reflected electromagnetic radiation beam 204 and partly transmitted through the second electrically insulating layer structure 908 as partly transmitted electromagnetic radiation beam 202'. The partly transmitted electromagnetic radiation beam 202' might be reflected at a surface 920 of the first electrically conductive layer structure 902. Also, the partly transmitted electromagnetic radiation beam 202' might be directed towards the first through hole 910 and be partly reflected and partly transmitted by the core layer structure 906. Due to different refraction indexes and due to the insulating material of the electrically insulating layer structure 908 having a reflectivity similar to the first electrically conductive layer structure 902, the reflected radiation beams 204 are non-clearly discernible from each other and cross-interference or cross-talking happens, so that it may not always be possible to clearly identify and detect the first through hole 910, in this case the fiducial is used as an alignment mark to help laser drilling of vias or placing components on the component carrier.

Another component carrier 1000 known from the prior art is shown in **Figure 10****.** In such embodiment there is also an electrically insulating layer structure 1006 and a second electrically conductive layer structure 1004 being stacked with a first electrically conductive layer structure 1002 and a second electrically insulating layer structure 1008 to form a stack, which also includes a core layer structure 1028. The second electrically conductive layer structure 1004 has a second through hole 1012, which is however not (even partially) aligned with the first through hole 1010, so that, also in this case, it may be difficult to discern the reflected electromagnetic beams 204 to detect and identify the first through hole 1010, being in this case the fiducial for quality evaluation.

The above-described quality evaluation method might however be problematic in particular in case a second electrically conductive layer structure is arranged beneath the electrically insulating layer structure, as the reflection from the second electrically conductive layer structure might have a reflectivity similar to that of the electrically insulating layer structure and to that of the first electrically conducting layer structure, so that cross-talking amongst the reflected radiation rays might happen and the measured reflected radiation cannot provide a reliable imaging of the component carrier to evaluate its quality. In particular, it might be difficult to detect the first through hole (fiducial) due to the reflection of the second electrically conductive layer structure. Also, there is almost no difference between the signal from the first through hole (fiducial) and the signal from the electrically conductive layer structures due to their strong reflection.

The conventional approach may show specifical drawbacks in the following specific example: there is used a component carrier with at least a first electrically conductive layer structure with a first through hole and arranged above an electrically insulating layer structure. Hereby, a filler material of the insulating layer structure comprises filler particles, for example SiO₂ particles with embedded air inclusions. The air inclusions in the SiO₂ particles reduce the dielectric constant of the electrically insulating layer structure and increase the reflectivity of the same by reducing its transmittivity. Accordingly, it may be made cumbersome or even impossible to reliably detect the through hole (fiducial) to evaluate the component carrier quality (during manufacture).

### Summary of the Invention

There may be a need to evaluate component carrier quality (in particular during the manufacture process) in an efficient and reliable manner.

A component carrier and a method for evaluating the component carrier are disclosed.

According to an aspect of the invention, there is described a component carrier comprising a stack, having:
a first electrically conductive layer structure with a first through hole;
a second electrically conductive layer structure with a second through hole; and
at least one electrically insulating layer structure, comprising a first insulating material, arranged between (sandwiched) the first electrically conductive layer structure and the second electrically conductive layer structure;
wherein the first through hole and the second through hole are (at least partially or fully) aligned in the stacking direction (along z) of the stack.

According to a further aspect of the invention, there is described a method for evaluating a component carrier (e.g. as described above), in particular under manufacturing (ine-line), the method comprising:
providing a component carrier (in particular as described above);
directing at least one electromagnetic radiation beam towards a test area comprising the first through hole of the component carrier;
receiving at least one reflected electromagnetic radiation beam;
evaluating the component carrier based on the received reflected electromagnetic radiation beam.

In the context of the present document, the term "electrically conductive layer structure" may in particular refer to a trace that comprises a metal, in particular copper. In particular, a metal trace may be configured as an elongated (preferably in the horizontal direction) electrically conductive structure that may serve for the transmission of signals, in particular high frequency signals and/or high speed signals. Additionally or alternatively, the metal trace may conduct electric current, in particular current in the range of 1 pA - 1000 A. Further, a metal trace with a rough surface may establish an adhesion with dielectric material, thereby enhancing the stability of a component carrier. Also, a metal trace having at least one smooth surface may provide higher speed of signal transmission. A metal trace may have for example a shape of an elongated trace, an annular ring or may be configured as a pad or block. Sidewalls of the metal traces can be straight or inclined/curved. The electrically conductive layer structure may also denote a pad to which a via may be connected with. The electrically conductive layer may comprise a via for the interconnection of two different layers. Furthermore, a bump comprising conducting material may be provided for the interconnection between a component carrier and separated components.

In the context of the present document, the term "electrically insulating layer structure" may particularly denote a layer made of or comprising a material having electrical insulating properties and, therefore, a relatively high dielectric constant. An electrically insulating layer structure may be placed between two consecutive electrically conductive layer structures for avoiding short circuits between them.

In the context of the present document, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In the present context, the test area can comprise a cavity, copper tracks and the likes. The test area may therefore comprise different elements forming the component carrier and/or one of the electrically insulating layer structure and/or one of the electrically conductive layer structure. Additionally, the test area may comprise organic (polymeric) material, for example epoxy resin, and/or metal, for example copper or silicon, and/or glass and/or ceramic material. In particular, the test area may comprise, among others, a fiducial mark, which has not to be the through hole, and which might be a component made of glass, silicon, ceramic and the like embedded in the component carrier, for example in the through hole, in the electrically conductive layer structure and/or in the electrically insulating layer structure. Such fiducial mark might have different shapes, such as a rounded one, rectangular one or a polygonal one. The fiducial mark might also be a through or non-through hole in the electrically insulating layer structure and/or in the electrically conductive layer structure.

According to an exemplary embodiment, the invention may be based on the idea that the quality of a component carrier (under manufacture) may be evaluated in an efficient and reliable manner, when there are provided at least two through holes (fiducial structures) in respective electrically conductive layer structures, and wherein said through holes are (at least partially) aligned in the vertical direction.

In such case, the reflected electromagnetic radiation from the second electrically conducting layer structure may be surprisingly efficiently reduced. Consequently, also cross-talking phenomena between the reflected electromagnetic radiation from the first electrically conductive layer structure and the second electrically conductive layer structure may be reduced, so that a more reliable imaging of the component carrier, an in particular of the fiducial structure, might be obtained, thus leading to more accurate results of the measured quality of the component carrier. Also, skew electromagnetic radiation being reflected from the first electrically conductive layer structure and/or from the second electrically conductive layer structure might be reduced.

According to the present invention, it may be furthermore possible to increase the alignment precision of the first electrically conductive layer structure and the second electrically conductive layer structure with each other by using the first through and the second through hole and by measuring a reflected radiation from a test area of the component carrier in which the first through hole and the second through hole are (at least partially) aligned.

### Exemplary Embodiments

According to an embodiment, the first through hole and the second through hole are congruent with each other. In the context of the present document, congruent means that the first through hole and the second through hole are coaxially aligned with each other.

In such case, it is possible to better identify the fiducial structure due to the reduced amount of the skew reflected electromagnetic radiation.

According to an embodiment, the first through hole and/or the second through hole is filled with the first insulating material. Therefore, there is no change in the optical behavior between the electrically insulating layer structure and the through hole, so that the skewed reflected electromagnetic radiation might be properly accounted of during the identification and evaluation process of the fiducial.

It might however also be provided that the first through hole and/or the second through hole are filled with another material as the first insulating material or that they are not filled with any material at all.

According to an embodiment, the first through hole and/or the second through hole is filled with filler-free material. This may bring the advantage of reducing noise signals, for example caused by (light) scattering of material, inside the first through hole and/or second through hole.

According to an embodiment, the first through hole and/or the second through hole is filled with a filler material, wherein the filler material has a lower reflectivity than the first insulating material and/or a higher transparency than the first insulating material. Thus, the reflected electromagnetic radiation from the first through hole and/or the second through hole might be further reduced, thus leading to improved results during imaging of the fiducial structure. Alternatively, the first through hole and/or the second through hole is filled with a filler material, wherein the filler material has a higher reflectivity than the first insulating material and/or a lower transparency than the first insulating material. Also, the filler material may impact other physical properties, for example Young's modulus to make the component carrier more resistant to warpage, which enhances the overall physical properties of the first insulating material. Also, the filler material may impact the electrical properties by modifying its dissipation factor and the dielectric constant.

According to an embodiment, the filler material is an optical transparent polymer, in particular an epoxy resin, or a ceramic material. Such materials have a particularly low reflectivity, so that the electromagnetic radiation reflected from the first through hole and/or the second through hole might be further reduced. Additionally and/or alternatively, the filler material may bring the advantage of improving the adhesion properties, resulting in high reliable integration of the first insulating material in the first through hole.

According to an embodiment, at least one further electrically insulating layer structure is arranged on the first electrically conductive layer structure. The at least one further electrically insulating layer structure arranged on the first electrically conductive layer structure might allow the component carrier structure to be connected to further elements, such as a carrier structure or an electronic component.

According to an embodiment, the one further electrically insulating layer structure is made of or comprises the same material or a different material with respect to the electrically insulating layer structure. Therefore, both electrically insulating layer structures have similar and/or identical optical properties with respect to an electromagnetic radiation used for imaging the fiducial structure. This may bring the advantage of having high flexibility in choice of manufacturing material, while still taking advantage of the optical properties.

According to an embodiment, the first electrically conductive layer structure has a first thickness and the second electrically conductive layer structure has a second thickness, wherein it is provided that the first thickness and the second thickness are equal. In such embodiment, the first through hole and the second through hole have therefore also the same thickness, thus having same optical properties in respect to an electromagnetic radiation.

It may also be the case, that the first electrically conductive layer structure has a different thickness from the second electrically conductive layer structure. This may bring the advantage of having a high flexibility in the design of the component carrier, while still taking advantage of the optical properties.

According to an embodiment, the first through hole has a first planar dimension and the second through hole has a second planar dimension, wherein it is provided that the first planar dimension and the second planar dimension are equal. The planar dimension might be a dimension in direction being perpendicular to a stacking direction (also referred to as vertical direction) of the component carrier. The planar direction might be a diameter, if the first through hole and/or the second through hole has a circular form. This may bring the advantage of fast manufacturing of the component carrier, while still reducing the phenomenon of cross-talking.

According to an embodiment, the first through hole and the second through hole have different first planar dimension and second planar dimension. In particular, it might be provided that the first through hole has a first planar dimension being bigger than a second planar dimension of the second through hole, so that the through hole with the larger planer dimension is closer to a source of electromagnetic radiation. In this case, the amount of the reflected electromagnetic radiation might be reduced, thus improving the identification of the fiducial structure. This may bring the advantage of having a high flexibility in the design of the component carrier, while still reducing the phenomenon of cross-talking.

According to an embodiment, the first insulating material comprises a material with filler particles, in particular nanoparticles, and/or silicon oxide particles. In this case, the light transmission properties of the first insulating material might be improved. In particular, this is the case if the nanoparticles are silicon oxide nanoparticles. Said filler particles may modify the physical properties, for example the reflective behavior regarding electromagnetic waves, of the first insulating material. This may bring the advantage of more selective and/or sensitive detection and/or evaluation of the reflected electromagnetic radiation beam.

According to an embodiment, at least part of the filler particles comprises fluid inclusions. This may bring the advantage of improved optical properties in combination with reducing the total weight of the component carrier, while still having reliable physical properties, for example Young's modulus.

According to an embodiment, at least part of the filler particles are hollow.

According to an embodiment, at least part of the filler particles are shaped as a sphere. In this case, the linear light transmission of the filler particles is improved, so that the linear light transmission of the insulating material might also be improved. This effect might be further improved if the filler particles also comprise bulk particles.

According to an embodiment, there are two or more filler particles having different physical/chemical properties. This may bring the advantage of tuning the physical/chemical properties, for example Young's modulus, or resistance against harsh chemicals (e.g. oxidation agents) while having reliable optical properties.

Fluid inclusions might comprise gaseous and/or liquid inclusions. Filler particles with fluid inclusions might modify the transparence of the particles themselves to electromagnetic radiation, so that the identification of the fiducial might be improved.

Within the context of the present document, a "hollow particle" may be a particle containing a fluid inclusion but no solid inclusions. Such hollow particles may have a qualitatively improved reflectivity of electromagnetic radiations when compared to bulk material, so that a better identification of the fiducial might be possible. Therefore, due to the improved reflectivity and the lower transmissibility it is possible to detect the signal and better identify the fiducial. In an example, a hollow particle may be a round shaped body, for example a sphere, having a closed solid shell. In another example, a hollow particle may have pores, creating indentations into the hollow particle.

According to embodiments of the present invention, the filler particle might be made of or comprise bulk material. Within the context of the present document, a "bulk material" may be a solid material without fluid inclusions.

According to embodiment of the present invention, the filler particles might be a mixture of hollow particles and of particles made of or comprising bulk material. This may bring the advantage of tuning the physical properties, for example hardness or stiffness, while having reliable optical properties.

According to an embodiment, the first electrically conductive layer structure and/or the second electrically conductive layer structure comprises or consists of metal, in particular copper. Therefore, the first electrically conductive layer structure and/or the second electrically conductive layer structure might be realized with material well known in the prior art in the field of component carriers.

According to an embodiment, the component carrier further comprises a core layer structure arranged at a surface of the second electrically conductive layer structure being opposite to a surface of the second electrically conductive layer structure at which the electrically insulating layer structure is arranged. Therefore, it is possible to use the component carrier in integrated chip architectures.

A core layer structure within the meaning of the present application may in particular be referred to a layer structure having a stabilizing effect for the component carrier to compensate warpage. The core layer structure may be comprising or made of a resin, in particularly an epoxy resin, more in particular a FR4 material. The material forming the core layer structure may be fully cured when the core layer structure is provided for forming the component carrier.

According to an embodiment, the first through hole and/or the second through hole has a round shape, preferable circular shape. This may bring the advantage of using standard manufacturing processes, for example mechanical and/or laser drilling. The first through hole and/or the second through hole might also be manufactured using standardized lithography processes.

According to an embodiment, the method might also be carried out on a semi-finished product comprising a stack structure according to the first aspect of the present invention. Therefore, the method described in the second aspect of the present invention is particularly flexible and versatile.

According to an embodiment, the electromagnetic radiation beam comprises at least one of infra-red, light, UV electromagnetic waves; and/or the electromagnetic radiation beam is provided as a source of visible light.

The electromagnetic radiation beam is preferably comprised in a range between 100 nm and 1500 nm. The source of the electromagnetic radiation beam may therefore also include laser sources, such as Nitrogen laser, excimer laser and CO₂ laser. If using a laser, the laser should be a low-power laser source in order not to damage the component carrier and/or the semi-finished product.

Therefore, different sources for the electromagnetic radiation might be provided.

It is also therefore provided, that the electromagnetic radiation might be in different regions of the visible, infra-red or ultra-violet radiation spectrum. The reflection of the electromagnetic radiation beam may depend on the wavelength. Thus, use of different electromagnetic radiation beams having different wavelength may bring the advantage of highly precise evaluation the reflected electromagnetic radiation beam.

According to an embodiment, the reflected electromagnetic radiation beam is received by a sensor or a plurality of sensors, wherein it is preferably provided that the sensor is a camera.

Therefore, the identification and the imaging of the fiducial might be easily performed. This may bring the advantage of simultaneously identifying a plurality of fiducials.

According to an embodiment, evaluating the reflected electromagnetic radiation comprises: comparing electromagnetic wave lengths for the reflected electromagnetic radiation beam, being reflected from a conductive material, in particular from a material of the first electrically conductive layer structure and/or of the second electrically conductive layer structure, and for the reflected electromagnetic radiation beam, being reflected from a non-conductive material, in particular from the first insulating material or from the filler material.

Therefore, it is possible to discern between the electromagnetic radiation being reflected from an electrically conductive layer structure, which might also be used to identify and image the fiducial, and the electromagnetic radiation reflected from the electrically insulating layer structure, which is reflected radiation being unrelated to the fiducial.

According to an embodiment, the method further comprises providing a through hole quality criterion to evaluate the measured reflected electromagnetic radiation.

Therefore, it may be possible to efficiently evaluate the quality of the fiducial structure. The quality criterion may be adapted based to the desired application and quality requirement.

In an embodiment, the component carrier is configured as one of the group consisting of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The electrically conductive layer structures and/or the electrically insulating layer structures may be parallel arranged in stack thickness direction.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.

### Brief Description of the Drawings

The aspects defined above and further aspects of the invention are apparent from the examples of embodiment to be described hereinafter and are explained with reference to these examples of embodiment.
Figure 1 shows schematically a component carrier according to a first embodiment of the present invention.
Figure 2 shows schematically a component carrier according to a second embodiment of the present invention.
Figure 3 shows schematically a system for carrying out a method for evaluating a component carrier according to the first embodiment of the present invention.
Figure 4 shows schematically a system for carrying out a method for evaluating a component carrier according to the second embodiment of the present invention.
Figure 5 shows an exemplary embodiment of a filler material according to the present invention.
Figures 6A and 6B show an exemplary embodiment of non-hollow particles and of hollow particles being present in the filler material according to Figure 5.
Figure 7 shows another exemplary embodiment of a filler material according to the present invention.
Figure 8 shows an exemplary embodiment of a bulk particle being provided in the filler material according to Figure 7.
Figure 9 shows a component carrier according to the prior art.
Figure 10 shows a component carrier according to the prior art.

### Detailed Description of the Drawings

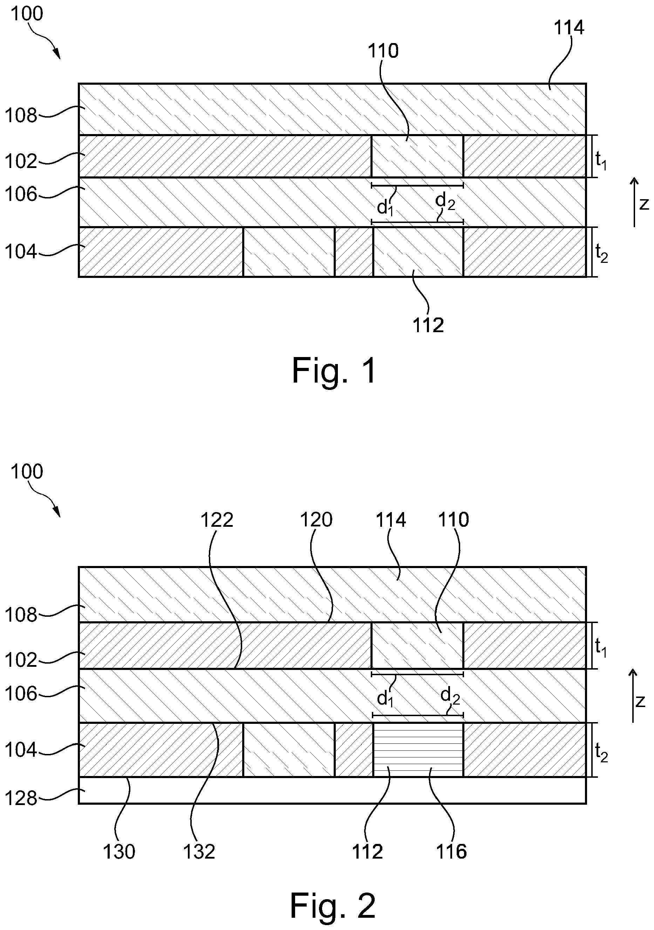

Figure 1 shows a component carrier 100 according to a first embodiment of the present invention.

The component carrier 100 comprises a first electrically conductive layer structure 102 and a second electrically conductive layer structure 104. Between the first electrically conductive layer structure 102 and the second electrically conductive layer structure 104 there is an electrically insulating layer structure 106 made of a first insulating material 114 such as an organic polymeric material, for example an epoxy resin.

A further electrically insulating layer structure 108 is arranged on a surface 120 of the first electrically conductive layer structure 102 opposite to the electrically insulating layer structure 106.

The further electrically insulating layer structure 108, the first electrically conductive layer structure 102, the electrically insulating layer structure 106 and the second electrically conductive layer structure 104 are stacked one on the other in a stacking or vertical direction z of the component carrier. As can be seen in Figure 1 the different layers of the stack are aligned parallel.

The first electrically conductive layer structure 102 has a first through hole 110, which serves as a fiducial for evaluating the component carrier 100, and in particular its quality, during the manufacturing process. On top of that, the first through hole 110 might be used to improve the manufacturing reliability of component carrier 100, as it affects the positioning of the elements placed within the component carrier 100, such as electrically conductive layer structures, electrically insulating layer structures or other components. The first through hole 110 might also be referred to as fiducial.

The second electrically conductive layer structure 104 has a second through hole 112. In the embodiment according to Figure 1, the first through hole and the second through hole 112 are congruent with each other, meaning that they are coaxial. It might however also be the case, that the first through hole 110 and the second through hole 112 are only partially aligned with each other.

The first through hole 110 and the second through hole 112 might have a diameter comprised between 10 µm and 2 mm. The electrically insulating layer structure 106 and the further electrically insulating layer structure 108 might have a thickness comprised between 2 µm and 100 µm. In an example, the first electrically insulating layer structure 106 and the further electrically insulating layer structure 108 may have the same thickness. In another example, the first electrically insulating layer structure 106 and the further electrically insulating layer structure 108 may have the same thickness different thickness. The first electrically conducting layer structure 102 and the second electrically conducting layer structure 104 might have a thickness comprised between 0.5 µm and 100 µm. In an example, the first electrically conductive layer structure 102 and the second electrically conductive layer structure 104 may have the same thickness. In another example, the first electrically conductive layer structure 102 and the second electrically conductive layer structure 104 may have the different thickness.

Furthermore, the first through hole 110 has a first planar dimension d1 and the second through hole 112 has a second planar dimension d2. The first planar dimension d1 and the second planar dimension d2 represent characteristic dimensions of the first through hole 110 and the second through hole 112, respectively, in a plane being perpendicular to the stacking direction z of the component carrier 100. In the embodiment according to Figure 1, both the first through hole 110 and the second through hole 112 both have a circular shape, so that the first planar dimension d1 and the second planar dimension are a diameter of the first through hole 110 and a diameter of the second through hole 112, respectively. According to the embodiment of Figure 1, the first planar dimension d1 and the second planar dimension d2 are equal. The invention however comprises also the case in which the first through hole 110 and/or the second through 112 do not have a circular shape and/or the case in which the first planar dimension d1 and the second planar dimension d2 are not equal. In particular, it might be provided that the first planar dimension d1 is smaller or bigger than the second planar dimension d2.

Also in the embodiment according to Figure 1, the first electrically conductive layer structure 102 has a first thickness t1 in the stacking or vertical direction z of the component carrier 100 and the second electrically conductive layer structure 104 has a second thickness t2 in the stacking or vertical direction z of the component carrier 100, wherein the first thickness t1 and the second thickness t2 are equal. However, it might also be the case that the first thickness and the second thickness are different.

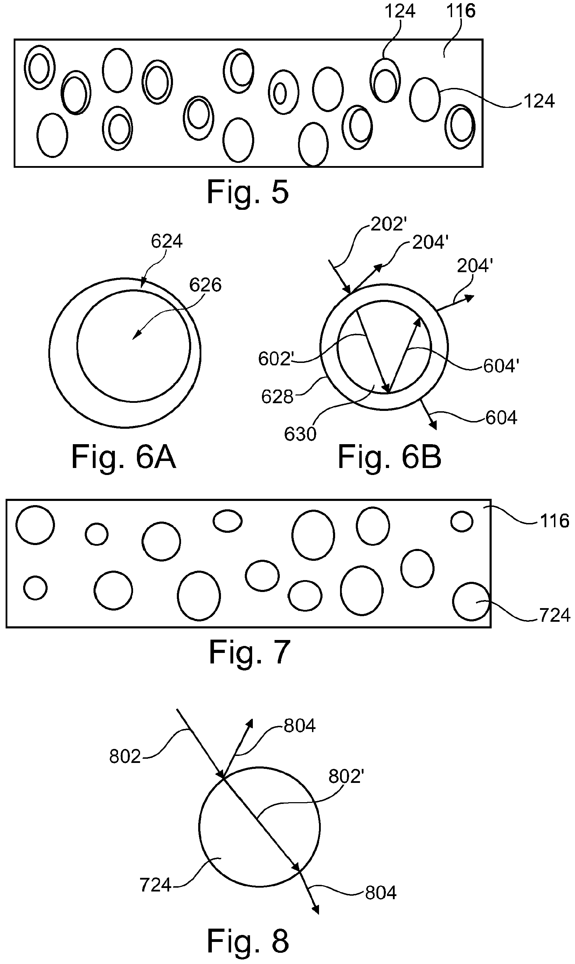

In the embodiment according to Figure 1, the first through hole 110 and the second through hole 112 are both filled up with the first insulating material 114, of which both the electrically insulating layer structure 106 and the further electrically insulating layer structure 108 are made. The first insulating material 114 might be, for example an epoxy resin having filler particles, akin to the filler particles 124 of Figure 5 (see below).

It might also be the case that the first through hole 110 and the second through hole 112 are filled with different insulating materials. For example, the first through hole 110 might be filled with the first insulating material 114 with or without filler particles 124 and the second through hole 112 might be filled with another material than the first insulating material 114.

It might however also be the case, that the first through hole 110 and the second through hole 112 are not filled with the first insulating material 114 and/or that they are hollow, meaning that they are not filled with any solid material at all. In such case, the reflection of the first through hole 110 and/or the second through hole 112 is very low, almost close to zero, so that the recognition of the first through hole and/or the second through hole might be rendered easier.

In the embodiment according to Figure 2, a core layer structure 128 arranged at a surface 130 of the second electrically conductive layer structure 104 being opposite to a surface 132 of the second electrically conductive layer structure 104 at which the electrically insulating layer structure 106 is arranged.

The core 128 allows the component carrier 100 of Figure 2 to be connected to other electronic components. The core 128 may therefore be suitable to carry the elements forming the component carrier 100 both in the finished product as well during the manufacturing process, so that the core 128 might be removed from the finished product. It might however also be the case that the core 128 is not removed from the finished product and that the core 128 is configured for connecting the component carrier 100 to other components in an electronic chip build-up. Electronic components, such as a die, an inductor, a resistor or a capacitor, might be embedded in the core 128.

Also, according to the embodiment of Figure 2, the second through hole 112 is filled with another material (filler material 116) than the first insulating material 114. The filler material 116 might be chosen to reduce reflection of electromagnetic waves from the second through hole 112, in order to be able to better identify and detect the first through hole 110. In particular, the filler material 116 might have a higher absorption and/or a higher transparency and/or a lower reflectivity with respect to the first insulating material 114.

It might also be the case, that the first through hole 110 is filled with another material rather than the first insulating material 114 and in particular with a material that improves the identification and the detection of the first through hole 110 by using electromagnetic waves, so that the first through hole 110 (fiducial) can be better identified and evaluated during the method for evaluating the component carrier 100, in particular during the manufacturing process of the same.

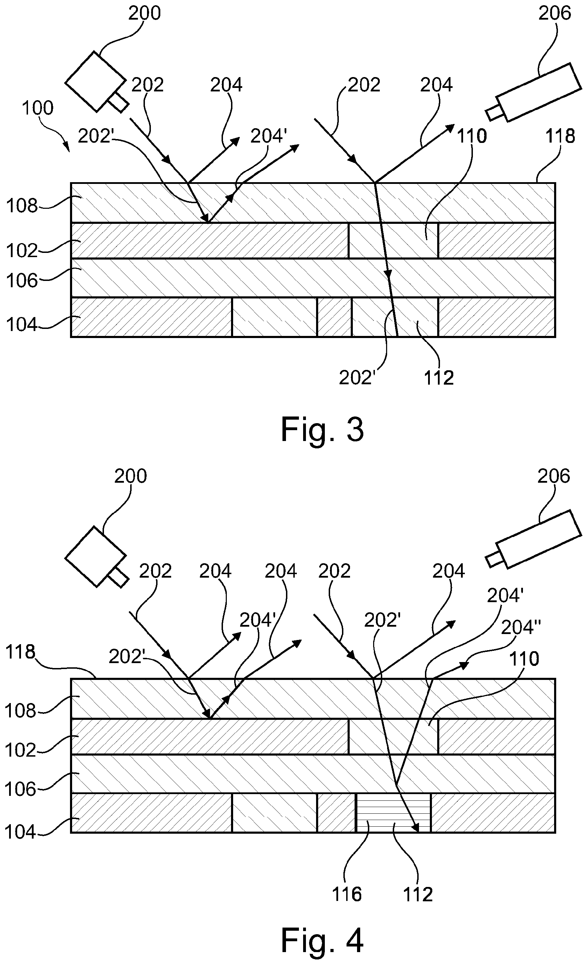

Figure 3 shows schematically a system for carrying out a method for evaluating a component carrier 100 according to the first embodiment of the present invention.

In Figure 3, a component carrier 100 according to the embodiment of Figure 1 is provided along with an electromagnetic radiation source 200. The electromagnetic radiation source 200 might be a source of visible light, infra-red radiation or ultra-violet radiation providing electromagnetic radiation, which is directed as a beam 202 towards a test area of the component carrier 100 comprising the first through hole 110.

The electromagnetic radiation beam 202 is partially reflected as a reflected radiation beam 204 at a surface 118 of the electrically insulating layer structure 106 facing the electromagnetic radiation source 200.

A part of the electromagnetic radiation beam 202 is refracted and transmitted through the electrically insulating layer structure 106. The refracted and transmitted radiation beam 202' might either be reflected by the first electrically conductive layer structure 102 (reflected electromagnetic beam 204' inside of the electrically insulating layer structure 106) and then is refracted at the surface 118 as a reflected electromagnetic beam 204. On the other side, the refracted and transmitted radiation beam 202' might be transmitted through the first hole 110 and the second hole 112.

A sensor 206 for detecting the reflected electromagnetic beams 204 and/or 204' is also provided in the system according to Figure 3. The sensor 206 might be a camera, in particular a CCD camera, capable of evaluating the reflected electromagnetic beams 204 and/or 204' to identify and image the first hole 110, that is the fiducial. The sensor 206 might be placed at an angle comprised between 0° and 90°, preferably between 20° and 70°, with respect to a horizontal plane perpendicular to a vertical (stacking or z) direction of the component carrier 100.

In the embodiment according to Figure 4, the second through hole 112 is filled with the filler material 116, which partly reflects and partly refracts and transmits the refracted and transmitted radiation beam 202'. The filler material causes an electromagnetic reflected beam 204" to be refracted at the surface 118 of the electrically insulating layer structure 106. The electromagnetic reflected beam 204" is kept low due to the properties of the filler material 116, so that the sensor 206 can better identify the first through hole 110, that is the fiducial.

Figure 5 shows an embodiment of the filler material 116. The filler material 116 of Figure 5 comprises particles 124, which might either be hollow particles or non-hollow particles. The use of particles 124 allows a change of the refraction, transmission, transparency and reflective indices of the filler material 116. In particular, the particles 124 are chosen to reduce the reflectivity of the filler material 116 in order to allow a better identification and detection of the first through hole 110.

An example of a non-hollow particle 624 is shown in Figure 6A. The non-hollow particle 624 is in the present example a silicon oxide particle with a fluid inclusion 626, such as gas (e.g. air) or liquid (silicone oil).

In Figure 6B particles 628 with a hollow volume 630 are shown. Through the hollow volume, the incident radiation beam 202' is split into a reflected radiation beam 204' and a transmitted radiation beam 602', which then either exits the particle 628 as transmitted radiation beam 604 or is reflected within the hollow volume 630 as reflected radiation beam 604' and then exits the particle as reflected radiation beam 204'.

In Figure 7 a filler material 116 with bulk particles 724 is shown. The filler material 116 comprises bulk particles 724 having different sizes. Preferably, the bulk particles 724 may have round shapes and/or may comprise silicon oxide material, more preferably silicon dioxide (SiO2). A detailed view of the bulk particle 724 is shown in Figure 8, in which the incident radiation beam 802, the transmitted radiation beam 802' and the reflected radiation beam 804 are shown. The bulk particles 724 are in particular chosen as to minimize reflection and maximize transmission of incident radiation beams.

It should be noted that the term "comprising" does not exclude other elements or steps, and the use of the item "a" does not exclude multiplicity. Elements described in conjunction with various embodiments can also be combined. It should also be noted that reference signs in the claims should not be interpreted as limiting the scope of the claims.

### List of reference signs:

- 100: component carrier
- 102: first electrically conductive layer structure
- 104: second electrically conductive layer structure
- 106: electrically insulating layer structure
- 108: further electrically insulating layer structure
- 110: first through hole
- 112: second through hole
- 114: first insulating material
- 116: filler material
- 118: surface
- 120: surface
- 122: surface
- 124: particle
- 130: surface
- 132: surface
- 200: electromagnetic radiation source
- 202: electromagnetic radiation beam
- 202': partly transmitted electromagnetic radiation beam
- 204: reflected electromagnetic radiation beam
- 204': reflected radiation beam
- 204": electromagnetic reflected beam
- 206: sensor
- 602': transmitted electromagnetic radiation beam
- 604: transmitted electromagnetic radiation beam
- 604': reflected electromagnetic radiation beam
- 604': reflected electromagnetic radiation beam
- 624: non-hollow particle
- 626: fluid inclusion
- 628: hollow particle
- 630: hollow volume
- 724: bulk particle
- 802: incident electromagnetic radiation beam
- 802': transmitted electromagnetic radiation beam
- 804: transmitted electromagnetic radiation beam
- 900: component carrier
- 902: first electrically conductive layer structure
- 906: core layer structure
- 908: second electrically insulating layer structure
- 910: through hole
- 920: surface
- 1000: component carrier
- 1002: first electrically conductive layer structure
- 1004: second electrically conductive layer structure
- 1006: electrically conductive layer structure
- 1008: second electrically conductive layer structure
- 1010: first through hole
- 1012: second through hole
- 1028: core layer structure

## Claims

1. Component carrier (100) comprising a stack, having:
a first electrically conductive layer structure (102) with a first through hole (110);
a second electrically conductive layer (104) structure with a second through hole (112); and
at least one electrically insulating layer structure (106), comprising a first insulating material (114), arranged between the first electrically conductive layer structure (102) and the second electrically conductive layer structure (104);
wherein the first through hole (110) and the second through hole (112) are aligned in the stacking direction (z) of the stack.

2. Component carrier (100) according to claim 1,
wherein the first through hole (110) and/or the second through hole (112) is filled with the first insulating material (114).

3. Component carrier (100) according to claim 1 or 2,
wherein the first through hole (110) and/or the second through hole (112) is filled with a filler material (116), and
wherein the filler material (116) has a lower reflectivity than the first insulating material (114) and/or a higher transparency than the first insulating material (114).

4. Component carrier (100) according to claim 3, wherein the filler material (116) is an optical transparent polymer, in particular an epoxy resin, or a ceramic material.

5. Component carrier (100) according to any of claims 1 to 4,
wherein at least one further electrically insulating layer structure (108) is arranged on the first electrically conductive layer structure (102).

6. Component carrier (100) according to claim 5, wherein the one further electrically insulating layer structure (108) is made of or comprises the same material or a different material with respect to the electrically insulating layer structure (106).

7. Component carrier (100) according to any of the claims 1 to 6, wherein the first electrically conductive layer structure (102) has a first thickness (t1) and the second electrically conductive layer structure (104) has a second thickness (t2), wherein it is provided that the first thickness (t1) and the second thickness (t2) are equal.

8. Component carrier (100) according to any of the claims 1 to 7, wherein the first through hole (110) has a first planar dimension (d1) and the second through hole (112) has a second planar dimension (d2), wherein it is provided that the first planar dimension (d1) and the second planar dimension (d2) are equal.

9. Component carrier (100) according to any of claims 1 to 8,
wherein the first insulating material (114) comprises a material with filler particles (124), in particular nanoparticles, and/or silicon oxide particles (624).

10. Component carrier (100) according to claim 9,
wherein at least part of the filler particles (624) comprises fluid inclusions (626); and/or
wherein at least part of the filler particles (628) are hollow; and/or
wherein at least part of the filler particles (124) are shaped as a sphere; and/or
wherein there are two or more filler particles (124) having different physical/chemical properties.

11. Component carrier (100) according to any of claims 1 to 10,
wherein the first electrically conductive layer structure (102) and/or the second electrically conductive layer structure (104) comprises or consists of metal, in particular copper.

12. Method for evaluating a component carrier (100), in particular under manufacturing, the method further comprising:
providing a component carrier (100) according to any of claims 1 to 13;
directing an electromagnetic radiation beam (202) towards a test area comprising the first through hole of the component carrier (100);
receiving at least one reflected electromagnetic radiation beam (204);
evaluating the component carrier (100) based on the received reflected electromagnetic radiation beam (204).

13. Method according to claim 12,
wherein the electromagnetic radiation beam comprises at least one of infra-red, light, UV electromagnetic waves; and/or
wherein the electromagnetic radiation beam is provided as one of a source of visible light, an infra-red radiation source or an ultra-violet radiation source.

14. Method according to claim 12 or 13,
wherein the reflected electromagnetic radiation beam is received by a sensor (206), wherein it is preferably provided that the sensor (206) is a camera.

15. Method according to claim 12,
wherein evaluating the reflected electromagnetic radiation (204) comprises:
comparing electromagnetic wave lengths
for the reflected electromagnetic radiation (204) beam, being reflected from a conductive material, in particular from a material of the first electrically conductive layer structure (102) and/or of the second electrically conductive layer structure (104), and
for the reflected electromagnetic radiation (204) beam, being reflected from a non-conductive material, in particular from the first insulating material (114) or from the filler material (116).
